# EUROPEAN PATENT APPLICATION

(11) **EP 0 847 087 A2**
(43) Date of publication of application: **10.06.1998**
(21) Application number: 97309819.7
(22) Date of filing: 04.12.1997
(51) Int. Cl.: H01L 23/495

(54) **A leadframe**

(30) Priority: 04.12.1996 US 32575 P
(71) Applicant: TEXAS INSTRUMENTS INCORPORATED, Dallas Texas 75265 (US)
(72) Inventor: Lamson, Michael A., Westminster, TX 75485 (US)
(74) Representative: Blanco White, Henry Nicholas

(57) **Abstract**

A multilayer leadframe for a semiconductor device (10,32,132,232) has at least one signal lead (20,120,220), a first conductive plane (24,124,224) having a first-conductive-plane extension (36), and a second-conductive-plane (28,128,228) having a second-conductive-plane-lead extension (38). The signal lead extension portion (30,130230), first conductive-plane-lead extension (36), and second conductive-plane-lead extension (38) may be formed with one or more steps (40,34,137,140,237,240) such that at least a portion of the extensions (30,36,38,130,230) are coplanar. Signal leads (20,120,220) first conductive layer (24,124,224) and second conductive layer (28,128,228) may be held in relative position during the bonding process and may be isolated by one or more isolation layers (22,26,122,126,222 and 226).

## Description

### TECHNICAL FIELD OF THE INVENTION

This invention relates generally to the field of leadframes for interconnections on semiconductor devices and more particularly, to a multilayer leadframe for molded packages.

### BACKGROUND OF THE INVENTION

Many modern electronic systems incorporate various modular electronic components. For example, personal computers may include modular electronic components in the form of dynamic random access memory units. Each of the modular electronic components may include an integrated circuit fabricated on a semiconductor substrate. Each modular electronic component may be coupled to the electronic system by a series of pins extending in a predetermined sequence from the body of a modular electronic component. The pins may be coupled to leads of a leadframe and external leads on the leadframe may be coupled to the electronic system.

The leadframe may be coupled to the integrated circuit during an aspect of the fabrication of the modular electronic component. Methods for coupling the leadframe to the integrated circuit include ball bonding, stitch bonding or wedge bonding. The leadframe may then be encapsulated in a plastic molding to form a completed package having external leads, or in some instances, balls for making contact with an electronic system. One technique for packaging semiconductor devices is to use plastic molding once bonding wires have been connected between the semiconductor chip or die and the leads or planes.

Semiconductor devices continue to improve with respect to their performance on a continuous basis As power dissipation and clock frequency continue to increase in semiconductor devices, the use of ground and power planes in the package is becoming more and more prevalent. The ground and power planes may lower the inductance paths for the ground and power currents, and thereby, reduce voltage drops and facilitate the control of the characteristic impedance of the signal leads or lines. Multilayer leadframes for molded packages may be useful to this end.

Multilayer leadframes for molded packages have a signal, power and ground layers or planes. The ground plane and power plane may comprise flat pieces of conducting material that carry currents underneath the conductor pattern or signal leads, and by adjusting the conductor pattern dimensions and the distance away from the ground or power plane, one may control the impedance to a large extent. General reference is made to United States Patent 5,160,893 to Lamson and assigned to Texas Instruments Incorporated.

### SUMMARY OF THE INVENTION

According to an aspect of the present invention, a multilayer leadframe has a signal lead having an extension portion, a first conductive plane having a first-conductive-plane extension, a second conductive plane having a second-conductive-plane extension, a first isolation layer disposed between at least a portion of the first conductive plane and the second conductive plane, a second isolation layer is disposed between the first conductive plane and the signal lead, and a molded housing is provided that encases at least a part of the extension portion of the signal lead, part of the first-conductive-plane extension and part of the second-conductive-plane extension to hold their relative position. According to another aspect of the present invention, the first isolation layer and second isolation layer have adhesives for holding the relative position of the signal lead, first conductive plane, and second conductive plan during bonding and molding.

According to another aspect of the present invention, a multilayer leadframe has a signal lead having an extension portion, a first conductive plane having a first-conductive-plane extension, a second conductive plane having a second-conductive-plane extension, a first isolation layer disposed between at least a portion of the first conductive plane and the second conductive plane, a second isolation layer is disposed between the first conductive plane and the signal lead, and a molded housing is provided that encases at least a part of the extension portion of the signal lead, part of the first-conductive-plane extension and part of the second-conductive-plane extension to hold their relative position. According to another aspect of the present invention, the first isolation layer and second isolation layer have adhesives for holding the relative position of the signal lead, first conductive plane, and second conductive plane during bonding and molding.

According to another aspect of the present invention, a method for manufacturing a packaged semiconductor device includes the steps of forming a first conductive plane having at least one first-conductive-plane extension; forming a second conductive plane having at least one second-conductive-plane extension; forming a plurality of signal leads each having an extension portion; placing a first isolation layer between the signal leads and the first conductive plane; placing a second isolation layer between the first conductive plane and the second conductive plane; forming the extension portion of the signal leads, the first-conductive-plane extension, the second-conductive-plane extension so that at least a portion of each extension is coplanar with the other extensions; and plastically molding the device including the portion of the extension portion of the signal lead, the first-conductive-plane extension, and second-conductive-plane extension to form the packaged semiconductor device.

A technical advantage of the present invention is that a leadframe may be associated with a ground plane and a power plane without requiring a joining operation such as welding. Another technical advantage of the present invention is that certain external leads of the multilayer leadframe are an integral part of the ground and power planes or extensions thereof. Another technical advantage of the present invention is that it may be easier to fabricate than other multilayer designs. Yet another technical advantage of the present invention is that ground and power planes may be extended closer to an outer edge of the package.

### BRIEF DESCRIPTION OF THE DRAWINGS

For a more complete understanding of the present invention, the objects and advantages thereof, reference is now made to the following descriptions taken in connection with the accompanying drawings in which:
Figure 1 is a plan view of half of a portion of a leadframe according to one aspect of the present invention;
Figure 2 is a perspective view of a portion of a multilayer leadframe according to an aspect of the present invention;
Figure 3 is a cross-sectional elevational schematic view of the leadframe of Figure 1 with the addition of a molding compound;
Figure 4 is a cross-sectional elevational schematic of a packaged die according to another aspect of the present invention; and
Figure 5 is a cross-sectional elevational schematic of a packaged die according to another aspect of the present invention.

### DETAILED DESCRIPTION OF THE EMBODIMENTS

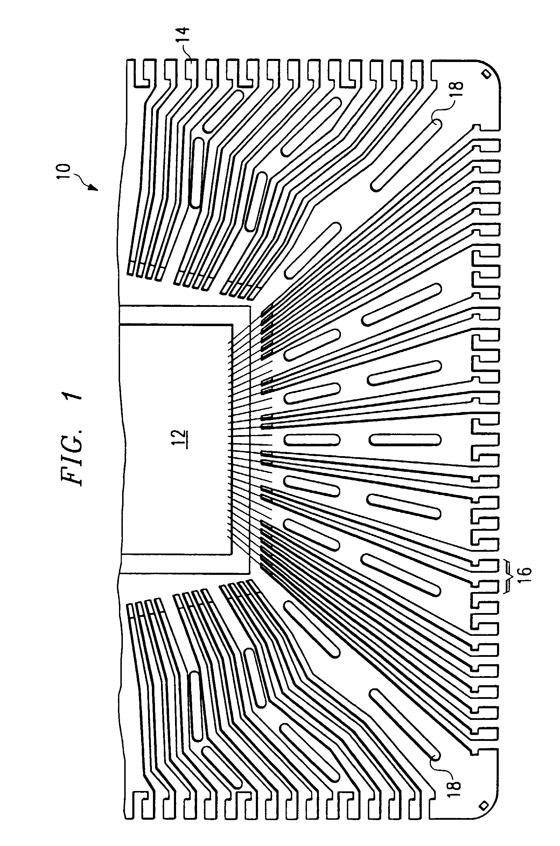

A preferred embodiment of the present invention and its advantages are best understood by referring to Figures 1 through 5 of the drawings, like numerals being used for like and corresponding parts of the various drawings.

Referring to Figure 1, a portion of a dam-bar-less leadframe 10 is shown. Before dam-bar-less packaging was implemented, dam-bars were included on leadframes which acted somewhat as a gasket for holding leads during the molding process and limiting flow of the resin. The interconnection of the leads by the dam presented a number of limitations. A dam-bar-less molding technique has clamps including a portion that acts as a gasket during the molding process.

Attached to leadframe 10 is a semiconductor chip or die 12. A number of leads, such as signal lead 14, are stamped or etched on leadframe 10 to provide for leads or lead fingers for wire bonding to die pads on semiconductor chip 12. For the embodiment shown in Figure 1, some of the leads are provided for lower frequency signals and some of the leads are provided for higher frequency signals. The higher frequency signals may be carried by conductor sets such as conductor set 16. Conductor sets, such as conductor set 16, are provided for operation in differential mode; that is, two conductors are used per signal with the signal going to the chip 12 on one conductor and returning on another. Other techniques may be used as well.

The high frequency signals handled by conductive sets, such as conductor set 16, handle signals up to approximately three gigahertz at the present. The differential mode has controlled impedances that utilize a ground plane and power plane beneath the conductor set. By adding planes, more isolation is obtained and more impedance control is possible.

Numerous holes, such as holes 18, may be provided through the various layers or planes, which will be described below, in order to allow the plastic molding compound to interlock between the top and bottom layers when the package is molded.

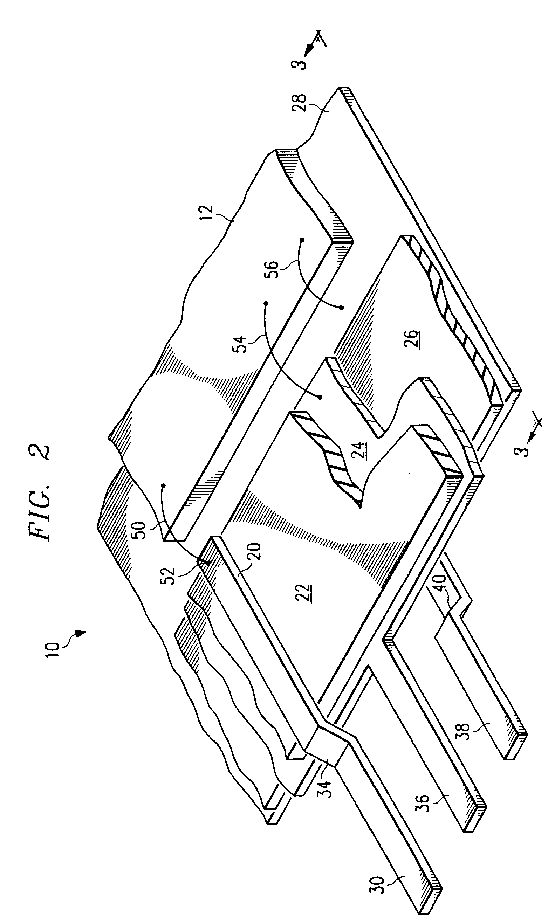

Referring to Figures 2 and 3, one embodiment of a multilayer dam-bar-less leadframe 10 is shown having signal lead 20, a first non-conductive or isolation plane or layer 22, a first conductive plane or layer 24 (which in this embodiment is a power plane), a second non-conductive or isolation layer or plane 26, and a second conductive plane or layer 28 (which in this embodiment is a ground plane). Semiconductor chip or die 12 may be positioned on a portion ground plane 28 as shown. An adhesive may be used between semiconductor chip 12 and ground plane 28. While Figure 2 only shows one signal lead 20, it is to be understood that leadframe 10 could, and typically would, include a plurality of signal leads, of which signal lead 20 is representative.

Signal lead 20 has a signal lead extension portion 30 that partially extends out of the molding 60 upon completion of the packaged semiconductor device 32. For the embodiment shown, signal lead 20 has a step portion 34 such that not all of signal lead 20 is coplanar. Step portion 34 may be formed by bends, arcs, or any type of manipulation of lead 20 to make different portions of lead 20 non-coplanar.

First conductive plane 24, which is a power plane in this embodiment, has a first conductive-plane-lead extension 36. For the specific embodiment shown, first conductive plane 24 and its extension 36 are coplanar. Second conductive plane 28, which is a ground plane in this embodiment, has a second-conductive-plane extension 38. Second-conductive-plane extension includes a step portion 40 such that not all of second conductive plane 28 is coplanar.

The signal lead extension portion 30 with corresponding step 34, first-conductive-plane extension 36, and second-conductive-plane extension 38 with corresponding step 40, cooperate to provide substantially coplanar portions that may be clamped and secured during the molding process. The extensions 30, 36 and 38 will become the leads exiting the packaged semiconductor device 32 for connection to a printed circuit board or the like. It is to be understood that while Figures 2 and 3 show only three extensions, numerous extensions could be involved for a given leadframe 10. In the embodiment presented, two of the extensions 30, 36 and 38 have been bent or formed such that at least a portion of each of the three extensions 30, 36, 38 are coplanar. In yet another alternative embodiment, a molding clamp can accommodate the different level extensions allowing them to remain non-coplanar during bonding and molding.

First isolation layer 22 may be formed from any of a number of suitable dielectric materials. For example, one suitable material is polymide. As shown best in Figure 3, isolation layer 22 may have an adhesive 42 on one side, and another adhesive 44 on the other. Similarly, second isolation layer 26 may be formed from any of a number of dielectric materials including a polymide. Also, second isolation layer 26 may have a first adhesive 46 on one side and a second adhesive 48 on the other.

As shown best by Figure 3, the internal edges of signal lead 20, first isolation layer 22, plane 24 and second isolation layer 26 may be staggered for convenient wire bonding to semiconductor chip 12. For example, wire bond 50 is shown electrically coupling a bonding target 52 on signal lead 20 to chip 12. Similarly, bonding wire 54 is shown electrically coupling plane 24 and semiconductor chip 12. Similarly, wire bond 56 is shown electrically coupling plane 28 and semiconductor chip 12.

Adhesive 42, 44, 46 and 48 holds the layers formed by signal leads 20, first isolation layer 22, power plane 24, second isolation layer 26, and ground 28 in place during the bonding and molding process. Once bonding is completed, plastic molding or resin 50 may be applied as part of the molding process.

The packaged semiconductor device 32 may thus be formed by making a power plane 24 by etching or stamping and electroplating a metal sheet with an appropriate metal; making a ground plane 28 by etching or stamping and electroplating a metal sheet with an appropriate metal; making a plurality of signal leads by etching or stamping and electroplating a metal sheet with an appropriate metal, applying a first isolation layer 22 having adhesives 42 and 44 (e.g. a dielectric tape); applying a second isolation layer 26 having adhesives 46 and 48 (e.g. another dielectric tape); angling or forming steps (e.g. steps 34 and 40) in at least two of the three conductive extensions 30, 36 and 38, such that at least a portion of extensions 30, 36 and 38 are coplanar; wire bonding chip 12 to signal leads 20, power plane 24 and ground plane 28 as appropriate; and applying a plastic molding or resin 60. The molding will hold the extensions 30, 36 and 38 to form a multilayer leadframe packaged device. The semiconductor device 32, which is here a multilayer plastic quad flat pack (MLPQFP), is thus formed without requiring any welding or joining operation during fabrication and the external leads are formed in part by direct or integral extensions of the ground and power planes.

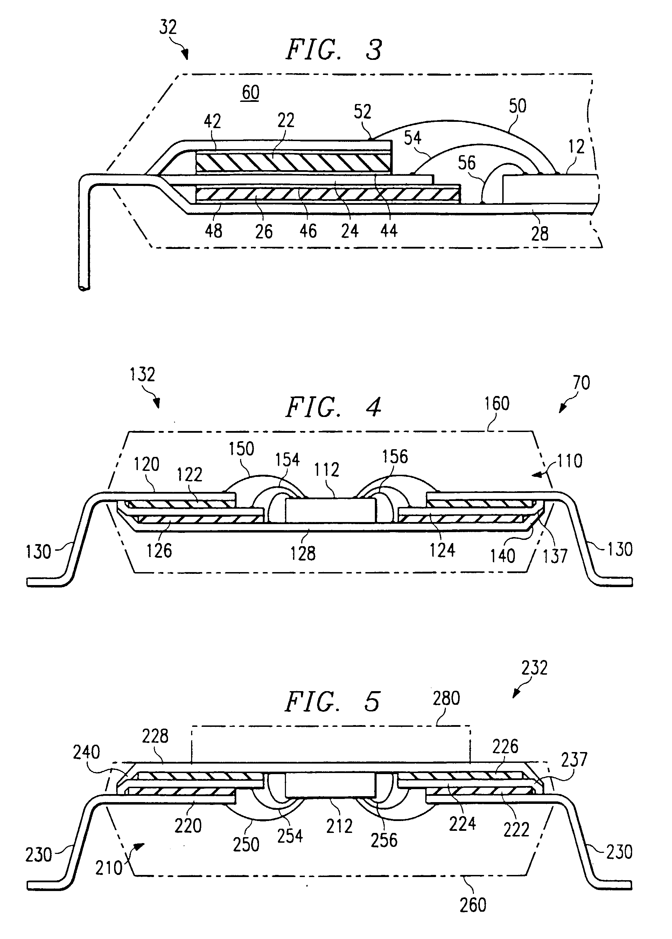

Referring to Figure 4, a packaged semiconductor device 132 is formed as shown. Semiconductor device 132 is formed with a dam-bar-less leadframe 110. This embodiment is similar in most respects to that shown in Figures 2 and 3, except that the signal layer or leads 120 do not have a step, such as step 34, but steps are used on other layers as will be explained. As before, a semiconductor chip 112 sits on a conductive ground plane 128. A first isolation layer 122 separates and holds signal leads 120 and conductive plane or power plane 124. A second isolation layer 126 separates and holds power plane 124 and ground plane 128. Wire bonds 150, 154 and 156 connect chip 112 to signal lead 120, power plane 124, and ground plane 128, respectively. The cross-sectional view of Figure 4 shows signal lead extension portion 130 extending out of a plastic molding 160 to form an external lead. A portion of ground plane 128 has step 140 to provide an extension portion that is coplanar with a portion of signal lead extension 130. Similarly, power plane 124 has step 137 to provide an extension portion of power plane 124 that is coplanar with a portion of signal lead extension 130. Steps 140 and 137 allow for extension portions of ground planes 128 and power plane 124 to be coplanar with a portion of signal lead extension 130 such that they may be readily packaged and molded using a dam-bar-less molding technique.

Referring to Figure 5, another embodiment is shown. Packaged semiconductor device 232 is formed with leadframe 210. Device 232 has a first conductive plane 224 having an extension with a step portion 237. A second conductive layer or plane 228 has a step portion 240. Signal lead 220 extends out to an external lead portion 230 signal lead 220, first conductive layer 224 and second conductive layer 228 may be electrically coupled to semiconductor chip 212 by bonding wires 250, 254 and 256, respectively. As explained in connection with previous embodiments, isolation layers 222 and 226 may be used with adhesives to separate and temporarily hold secure signal lead 220, first conductive layer 224 and second conductive layer 228 during bonding and molding. Packaged device 232 of Figure 5 is made analogously with that of Figure 4, except that lead extensions 230 are shown bent or stopped in an opposite direction, and plastic molding 260 is placed in a limited fashion such that a portion of ground plane or second conductive plane 228 opposite the side on which chip 212 is placed, is not covered by plastic molding 260. This allows a surface of plane 228 to be exposed or alternatively, to have a heat sink 280 (shown in hidden lines) attached to plane 229. Exposing a surface of plane 228 or attaching a heat sink 280 allows for additional heat dissipation from semiconductor device 232.

Although the invention has been particularly shown and described by the foregoing detailed description, it will be understood by those skilled in the art that various other changes in formed and detail may be made without departing from the spirit and scope of the invention.

## Claims

1. A leadframe comprising:
a first conductive plane having a first-conductive-plane extension;
a second conductive plane having a second-conductive-plane extension;
a first isolation layer disposed between at least a portion of the signal lead and a first conductive plane;
a second isolation layer disposed between at least a portion of the first conductive plane and a second conductive plane; and
a molded housing encasing at least part of an extension portion of a signal lead, part of the first-conductive-plane extension, and part of the second-conductive-plane extension for holding their relative position.

2. The leadframe of Claim 1, further comprising:
first and second adhesive layers attached to the first isolation layer; and
third and fourth adhesive layers attached to attached to the second isolation layer.

3. The leadframe of Claim 1 or Claim 2 wherein the first conductive plane comprises a power plane.

4. The leadframe of any of Claims 1 to 3 wherein the second conductive plane comprises a ground plane.

5. The leadframe of any of Claims 1 to 4 further comprising:
a die pad disposed on the second conductive plane for receiving a semiconductor die.

6. The leadframe of anyof Claims 1 to 5, wherein the extension portion of the signal lead, a portion of the first-conductive-plane extension, and a portion of the second-conductive-plane extension are coplanar.

7. The leadframe of any of Claims 1 to 6, wherein the extension portion of the signal lead has a stepped portion.

8. The multilayer leadframe of any of Claims 1 to 7, wherein a portion of the first-conductive-plane extension has a stepped portion.

9. The multilayer leadframe of any of Claims 1 to 8, wherein the second-conductive-plane extension has a stepped portion.

10. The multilayer leadframe of any of Claims 1 to 9, wherein the first isolation layer comprises a polymide tape.

11. A leadframe comprising:
a first conductive plane having at least one first-conductive-plane extension;
a first isolation layer disposed between at least a portion of a signal lead and the first conductive plane; and
a molded housing encasing at least part of an extension portion of the signal lead and at least part of the first-conductive-plane extension to hold the relative position of the signal lead and first conductive plane.

12. The leadframe of Claim 11 further comprising:
a second conductive plane having at least one second-conductive-plane extension; and
a second isolation layer disposed between at least a portion of the first conductive plane and the second conductive plane.

13. The leadframe of Claim 11 or Claim 12 further comprising:
a heat sink thermally coupled to a side of the first conductive plane.

14. A method for manufacturing a packaged semiconductor device comprising the steps of:
forming a first conductive plane having at least one first-conductive-plane extension;
forming a second conductive plane having at least one second-conductive-plane extension;
forming a plurality of signal leads:
placing a first isolation layer between the first conductive plane and the second conductive plane;
forming an extension portion of each of the plurality of signal leads, the first-conductive-plane extension, and second-conductive-plane extension so that at least a portion of each extension is coplanar with at least one other extension; and
plastically molding the device including a portion of the extension portion of the signal lead, the first-conductive-plane extension, and the second-conductive plane extension to form the packaged semiconductor device.

15. The method of Claim 14, wherein the step of placing a first isolation layer between the signal leads and first conductive plane comprises the step of placing a first isolation layer between the signal leads and first conductive plane with the first isolation layer having adhesives on a first side and a second side so as to maintain the first conductive plane and signal leads in contact with the first isolation layer.

16. The method of Claim 14 or Claim 15, wherein the step of placing a second isolation layer between the first conductive plane and the second conductive plane comprises the step of placing a second isolation material between the first conductive plane and the second conductive plane with the second isolation material having adhesives on a first side and a second side so as to maintain the first conductive plane and second conductive planes in contact with the second isolation layer.

17. The method of any of Claims 14 to 16, wherein the step of forming the extension portion of the signal leads, the first-conductive-plane extension, and second-conductive-plane extension comprises the step of bending the extension portion of each signal lead of the plurality of signal leads to provide a stepped portion therein.

18. The method of any of Claims 14 to 17, wherein the step of forming the extension portion of the signal leads, the first-conductive-plane extension, and second-conductive-plane extension comprises the step of bending the second-conductive-plane extension to provide a stepped portion therein

19. The method of any of Claims 14 to 18, wherein the step of forming the extension portion of the signal leads, the first-conductive-plane extension, and second-conductive-plane extension comprises the step of bending the first-conductive-plane extension to provide a stepped portion therein.

20. The method of any of Claims 14 to 19, further comprising the step of coupling a heat sink to a surface of the second conductive plane for facilitating heat transfer.
